# EUROPEAN PATENT APPLICATION

(11) **EP 3 506 248 A2**
(43) Date of publication of application: **03.07.2019**
(21) Application number: 18197142.5
(22) Date of filing: 27.09.2018
(51) Int. Cl.: G09G 3/3233, G09G 3/3225

(54) **ORGANIC LIGHT-EMITTING DISPLAY DEVICE**

(30) Priority: 27.12.2017 KR 20170181293
(71) Applicant: LG Display Co., Ltd., SEOUL, 07336 (KR)
(72) Inventor: PARK, Jungsoo, 10845 Paju-si, Gyeonggi-do (KR); KIM, Sohyun, 10845 Paju-si, Gyeonggi-do (KR)
(74) Representative: Viering, Jentschura & Partner mbB Patent- und Rechtsanwälte

(57) **Abstract**

A display device (100) includes a substrate (301), a bottom shield metal layer (380), a driving transistor (D-Tr), and an organic light emitting diode (OLED). The bottom shield metal layer (380) is on the substrate and is coupled to a voltage source (VBSM) . The driving transistor is above the bottom shield metal layer. The driving transistor includes a source terminal and a drain terminal. A first one of the terminals of the driving transistor is coupled to a reference voltage (Vref) for setting a voltage value at the first terminal. The coupling of the bottom shield metal layer to the voltage source is independent of the coupling of the first terminal to the reference voltage. The OLED includes a first electrode that is coupled to the first terminal of the driving transistor.

## Description

### CROSS-REFERENCE TO RELATED APPLICATIONS

This application claims the priority of Korean Patent Application No. 10-2017-0181293 filed on December 27, 2017, in the Korean Intellectual Property Office.

### BACKGROUND

### Technical Field

The present disclosure relates to an organic light-emitting display device employed by a virtual reality (VR) device.

### Description of the Related Art

Virtual Reality (VR) is an environment that virtually provides a viewer with experiences/environments that she/he cannot have in the real world by way of stimulating the five senses of the human body (sight, hearing, smell, taste, touch) by using artificial technology. Virtual reality can be implemented by using various hardware and software modules such as an input device, an output device, a device driver software, and a content. Typically, a VR device may include an input unit, a processing unit, and an output unit. Among them, the output unit may be implemented as a display device having increased immersion level.

A display device for displaying information plays a very important role for VR devices. In particular, in order to get a viewer immersed into virtual reality, the shape of the VR device is important as well as image presentation performance such as resolution. Accordingly, a head mounted display (HMD) device is frequently used as a kind of VR display devices, which is worn on a user's head. A light and thin display device is appropriate for HMD devices.

Recently, an organic light-emitting display device for an output unit (display device) of VR devices including HMD device has been developed. An organic light-emitting display device employs a self-luminous element using a thin emission layer between the electrodes and is advantageous in that it is light and thin. Accordingly, researches for improving/ modifying the structure, operation and function of the organic light-emitting display device for VR devices are ongoing, considering the use characteristics of VR devices.

### SUMMARY

In view of the above, an object of the present disclosure is to provide an organic light-emitting display device for use in a VR device and a method for driving the same. It should be noted that objects of the present disclosure are not limited to the above-described objects, and other objects of the present disclosure will be apparent to those skilled in the art from the following descriptions.

Disclosed is a display device including a substrate, a bottom shield metal layer, a driving transistor, and an organic light emitting diode (OLED). The bottom shield metal layer is on the substrate and is coupled to a voltage source. The driving transistor is arranged above the bottom shield metal layer. The driving transistor includes a source terminal and a drain terminal. A first one of the terminals of the driving transistor (e.g., the source terminal) is coupled to a reference voltage for setting a voltage value at the first terminal. The coupling of the bottom shield metal layer to the voltage source is independent of the coupling of the first terminal to the reference voltage. The OLED includes a first electrode that is coupled to the first terminal of the driving transistor.

In some embodiments, a voltage value of the voltage source is lower than a voltage at which a back channel is formed in the driving transistor.

In another embodiment, the voltage source has a first voltage value during a first period when the OLED is configured not to emit light, and has a second voltage value during a second period when the OLED is configured to emit light.

In one embodiment, the first voltage value is lower than the second voltage value.

In another embodiment, the first voltage value is 0V.

In some embodiments, the first period is a data write and hold period for storing display data to a capacitor of the display device.

In some embodiments, the display device operates in a global shutter operation mode, wherein every pixel of the display device is configured to turn on or off simultaneously.

In some embodiments, a connection between the bottom shield metal layer and the voltage source is made in an inactive area of the display device where no pixels are present.

The display device further comprises a switch coupled to the OLED. The switch is configured to couple a second electrode of the OLED to a first voltage to turn on the OLED, or to couple the second electrode of the OLED to a second voltage to turn off the OLED.

In some embodiments, the bottom shield metal layer at least partially overlaps with a semiconductor layer of the driving transistor.

In some embodiments, the bottom shield metal layer and a gate of the driving transistor are at opposite sides of a semiconductor layer of the driving transistor.

Disclosed is also a method for operating a display device. During a first period when an organic light emitting diode (OLED) of the display device does not emit light, a first voltage is provided to a bottom shield metal layer. During a second period when the OLED of the display device emits light, a second voltage is provided to the bottom shield metal layer, the first voltage and the second voltage being different.

In some embodiments, the first voltage is lower than the second voltage.

In some embodiments, the first period is a data write and hold period for storing display data to a capacitor of the display device.

In some embodiments, the display device operates in a global shutter operation mode, wherein every pixel of the display device turns on or off substantially at a same time.

A display device may include a substrate, an array of thin film transistors on the substrate, and a shield metal between at least one of the thin film transistors and the substrate. The array of thin film transistors may be arranged in an active area of the display device. The shield metal receives a first voltage during an addressing period and a second voltage during an emission period, the first voltage being different from the second voltage.

In some embodiments, the shield metal is held at a constant voltage during the addressing period, thereby improving the residual image and response speed.

In some embodiments, the shield metal has a specific voltage during the emission period, thereby reducing luminance degradation, wherein the specific voltage is larger than 0V.

In some embodiments, the first voltage is a ground voltage and the second voltage is 2.5 V or more.

In one embodiment, the display device further includes an organic light-emitting diode connected to at least one of the thin film transistors, and a switch turning on the organic light-emitting diode in the emission period and turning off the organic light-emitting diode in the addressing period.

According to exemplary embodiments of the present disclosure, issues of recoverable residual images and luminance degradation can be reduced. Further, according to exemplary embodiments of the present disclosure, an organic light-emitting display device can be fabricated more simply. It should be noted that effects of the present disclosure are not limited to those described above and other effects of the present disclosure will be apparent to those skilled in the art from the following description.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 shows an example of an organic light-emitting display device that may be included in an electronic device;
FIGS. 2A to 2D are exemplary diagrams showing an organic light-emitting display device for use in a virtual reality (VR) device and driving thereof; and
FIGS. 3A to 3C are exemplary diagrams showing an organic light-emitting display device according to an exemplary embodiment of the present disclosure and driving the same.

### DETAILED DESCRIPTION OF THE PREFERRED EMBODIMENT

Advantages and features of the present invention and methods to achieve them will be elucidated from exemplary embodiments described below in detail with reference to the accompanying drawings. However, the present disclosure is not limited to exemplary embodiments disclosed herein but may be implemented in various different ways. The exemplary embodiments are provided for making the disclosure of the present disclosure thorough and for fully conveying the scope of the present disclosure to those skilled in the art. It is to be noted that the scope of the present disclosure is defined by the claims.

The figures, dimensions, ratios, angles, the numbers of elements given in the drawings are merely illustrative and are not limiting. Like reference numerals denote like elements throughout the descriptions. Further, in describing the present disclosure, descriptions on well-known technologies may be omitted in order not to unnecessarily obscure the gist of the present disclosure. It is to be noticed that the terms "comprising," "having," "including" and so on, used in the description and claims, should not be interpreted as being restricted to the means listed thereafter unless specifically stated otherwise. Where an indefinite or definite article is used when referring to a singular noun, e.g. "a, " "an," "the," this includes a plural of that noun unless specifically stated otherwise. In describing elements, they are interpreted as including error margins even without explicit statements.

In describing positional relationship, such as "an element A on an element B, " "an element A above an element B, " "an element A below an element B," and "an element A next to an element B," another element C may be disposed between the elements A and B unless the term "directly" or "immediately" is explicitly used. As used herein, a phrase "an element A on an element B" refers to that the element A may be disposed directly on the element B and/or the element A may be disposed indirectly on the element B via another element C. As used herein, phrases "an element A connected to an element B" or "an element A coupled with an element B" refer to that the element A may be directly connected to/coupled with the element B, that that another element C may be interposed between the element A and the element B, and/or that the element A may be indirectly connected to/coupled with the element B via another element C.

The terms first, second and the like in the descriptions and in the claims are used for distinguishing between similar elements and not necessarily for describing a sequential or chronological order. These terms are used to merely distinguish one element from another. Accordingly, as used herein, a first element may be a second element within the technical idea of the present disclosure.

The drawings are not to scale and the relative dimensions of various elements in the drawings are depicted schematically and not necessarily to scale. Hereinafter, exemplary embodiments of the present disclosure will be described in detail with reference to the accompanying drawings.

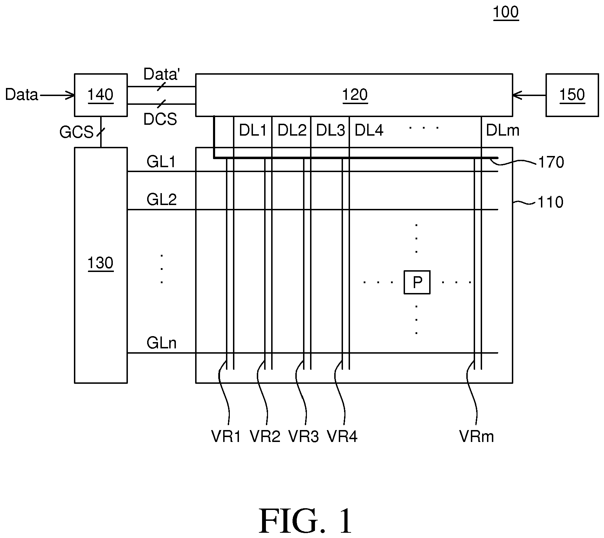

**FIG. 1** shows an example of an organic light-emitting display device that may be included in an electronic device.

An organic light-emitting display device 100 includes at least one active area, in which an array of pixels is formed. One or more inactive areas may be disposed around the active area. That is, the inactive areas may be adjacent to one or more sides of the active area. The shape/arrangement of the active area and the inactive areas are not particularly limited herein. The active area and the inactive areas may have shapes appropriate for the design of an electronic device employing the organic light-emitting display device 100. The electronic device may be a virtual reality (VR) display device may have a pentagon shape, a hexagon shape, a circle shape, an ellipse shape, etc., for example.

Each of the pixels in the active area may be associated with a pixel circuit. The pixel circuit may include at least one switching transistor and at least one driving transistor on a backplane. Each pixel circuit may be electrically connected to a gate line and a data line to communicate with one or more driving circuits such as a gate driver and a data driver. The driving circuits may be implemented as a TFT (thin-film transistor) in the inactive areas. Alternatively, the driving circuits may be mounted on a separate printed circuit board and may be coupled with interconnect interface (pads/bumps, pins, etc.) disposed in the inactive areas via circuit films such as such as a FPCB (flexible printed circuit board), a COF (chip-on-film) and a TCP (tape-carrier-package). The arrangements of such pixel circuits and driving circuits are illustrated in FIG. 1.

As shown in FIG. 1, in the display panel 110, a plurality of data lines DL1, DL2, DL3, ..., DLm may be arranged in a first direction, and a plurality of gate lines GL1, GL2, ..., GLn may be arranged in a second direction intersecting the first direction. In addition, a plurality of pixels P may be arranged in a matrix.

When a gate line GL is opened, a data driver 120 converts the image data Data' received from a controller 140 into a data voltage Vdata in the form of analog signal to apply the data voltage Vdata to the data lines DL1, DL2, DL3 , ..., DLm.

A gate driver 130 sequentially supplies gate signals of an on-voltage or an off-voltage to the gate lines GL1, GL2, ..., and GLn under the control of the controller 140. The gate driver 130 may be located either on both sides of the display panel 110 or only on one side, depending on the driving manner. In addition, the gate driver 130 may include a plurality of gate driver integrated circuits (ICs), which may be connected to a bonding pad of the display panel 110 by tape automated bonding (TAB) or chip-on-glass (COG), or may be implemented as a gate-in-panel (GIP) such that they may be directly disposed on the display panel 110. Each of the gate driver ICs may include a shift register, a level shifter, etc.

The controller 140 controls the data driver 120 and the gate driver 130 and applies control signals to the data driver 120 and the gate driver 130. The controller 140 starts scanning in accordance with the timing to be implemented in each frame, converts the image data Data input from a host system into a data signal format used by the data driver 120 to output the converted image data Data', and controls the data drive at an appropriate time according to the scanning. To control the data driver 120 and the gate driver 130, the controller 140 may receive timing signal such as a vertical synchronization signal Vsync, a horizontal synchronization signal Hsync, an input data enable signal and a clock signal and may generate a variety of control signals to the data driver 120 and the gate driver 130. For example, to control the gate driver 130, the controller 140 may output gate control signals (GCSs) including a gate start pulse (GSP), a gate shift clock (GSC), a gate output enable (GOE) signal, etc. To control the data driver 120, the controller 140 may output data control signals (DCSs) including a source start pulse (SSP), a source sampling clock (SSC), a source output enable (SOE) signal, etc.

The organic light-emitting display device 100 may further include a power controller 150 for applying a variety of voltages or currents to the display panel 110, the data driver 120 and the gate driver 130 or for controlling the variety of voltages or currents to be supplied. The power controller 150 is also referred to as a power management IC (PMIC).

The OLED display 100 may include a plurality of reference voltage lines VR1, VR2, VR3, ..., VRm for applying reference voltages Vref to the pixels, and a reference voltage link line 170 commonly connected to the plurality of reference voltage lines VR1, VR2, VR3, ..., VRm. The organic light-emitting display device 100 may also include high-/low-potential voltage lines for applying a high-potential voltage VDD and a low-potential voltage VSS associated with the driving of the pixel circuits.

The organic light-emitting display device 100 may include a variety of additional elements for generating various signals or for driving the pixels in the active area. The additional elements for driving the pixels may include an inverter circuit, a multiplexer, an electro static discharge circuit, etc. The organic light-emitting display device 100 may include elements associated with other features than driving the pixels. For example, the organic light-emitting display device 100 may include additional elements for providing a touch sense feature, a user authentication feature (e.g., fingerprint recognition), a multi-level pressure sense feature, a tactile feedback feature, etc. The above-mentioned additional elements may be disposed in the inactive areas and/or an external circuit connected to the interconnect interface.

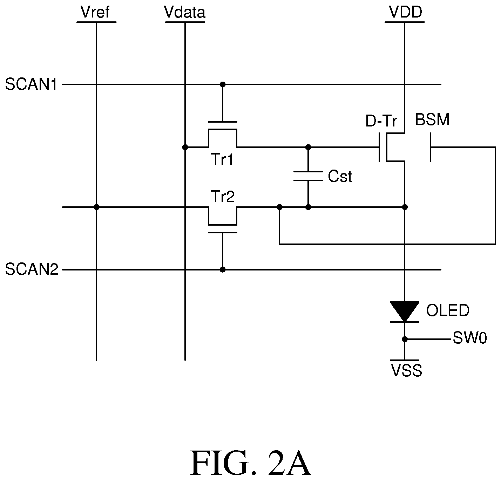

**FIGS. 2A** **to2D** are exemplary diagrams showing an organic light-emitting display device used in a virtual reality (VR) device and driving thereof.

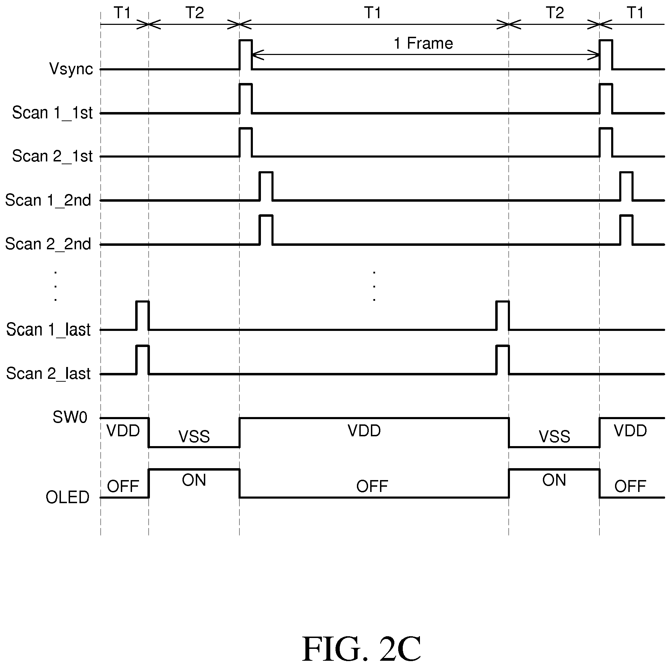

**FIG. 2A** **is** a diagram illustrating an example of a unit pixel circuit of the organic light-emitting display device. **FIG. 2C** is a timing diagram illustrating driving timings of the circuit shown in FIG. 2A. In the organic light-emitting display device used in a VR device, a process of transmitting an image signal (display information) to each pixel is similar to that of typical organic light-emitting display devices.

Referring to FIGS. 2A and 2C, each unit pixel circuit (hereinafter referred to as a pixel circuit) of the organic light-emitting display device 100 includes an organic light-emitting diode (OLED), and a driving transistor D-Tr for supplying current to the OLED to drive the OLED.

The OLED includes a first electrode (e.g., an anode) and a second electrode (e.g., a cathode). An organic emission layer may be disposed between the first electrode and the second electrode. The first electrode of the OLED is connected to the driving transistor D-Tr, and the second electrode thereof is connected to the low-level voltage terminal VSS. The low-level voltage (or base voltage) may be changed between a low voltage and a high voltage under the control of the power controller 150.

A first node of the driving transistor D-Tr is a gate node (G node) and receives a first voltage. A second node of the driving transistor D-Tr is a source node (S node) and receives a second voltage. The first voltage may be a data voltage Vdata for the respective pixel, and the second voltage may be a reference voltage Vref. A third node of the driving transistor D-Tr is a drain node (D node) and receives the high-level voltage VDD. In summary, the driving transistor D-Tr includes the first node (G node) at which the data voltage Vdata is applied, the second node (S node) connected to the first electrode of the OLED, and the third node (D node) connected to the high-level voltage terminal VDD.

The pixel circuit may include a capacitor, e.g., a storage capacitor Cst, connected between the first node (G node) and the second node (S node) of the driving transistor D-Tr. The capacitor Cst holds a constant voltage for one frame.

In addition to the driving transistor D-Tr, each pixel circuit may further include one or more transistors. In some implementations, each pixel circuit may further include one or more capacitors. In the circuit configuration shown in FIG. 2A, the pixel circuit may further include a first transistor Tr1 and a second transistor Tr2.

The first transistor Tr1 is turned on/off or switched by the first gate signal SCAN1 applied through the first gate line. When the first transistor Tr1 is turned on by the first gate signal SCAN1, the first transistor Tr1 applies the data voltage Vdata to the first node (G node) of the driving transistor D-Tr. The second transistor Tr2 is turned on/off or switched by the second gate signal SCAN2 applied through the second gate line. When the second transistor Tr2 is turned on by the second gate signal SCAN2, the second transistor Tr2 applies the reference voltage Vref to the second node (S node) of the driving transistor D-Tr.

The capacitor Cst holds the data information Vgs that is equal to the difference between the data voltage Vdata (= VG) applied to the first node (G node) of the driving transistor D-Tr and the reference voltage Vref (= VS) applied to the second node (S node) for one frame.

A bottom shield metal layer BSM to be described later may be connected to a node of the source electrode of the driving transistor D-Tr.

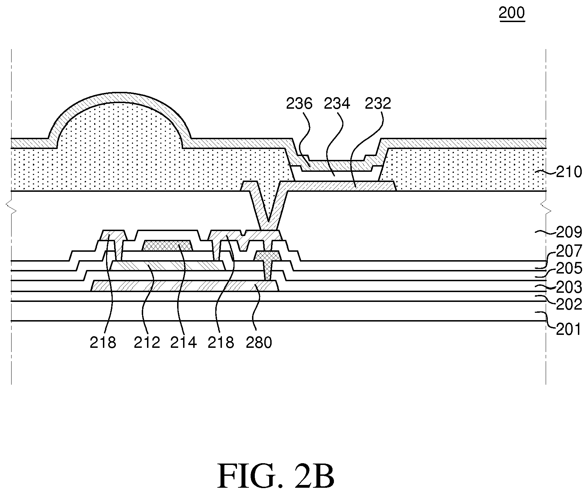

**FIG. 2B** is a cross-sectional view of the organic light-emitting display device. In the organic light-emitting display device 200, a thin-film transistor (212, 214 and 218), an organic light-emitting element (232, 234 and 236), and various functional layers are formed on a base layer 201 in an active area A/A.

The base layer 201 supports various elements of the organic light-emitting display device 200. The base layer 201 may be made of a transparent insulation material such as glass, plastic, etc. As used herein, the term "substrate" (or "array substrate") may also refer to the base layer 201 as well as elements and functional layers formed thereon, e.g., a switching TFT, a driving TFT, an organic light-emitting element, a protective film, etc.

A buffer layer 202 may be disposed on the base layer 201. The buffer layer is a functional layer for protecting a thin-film transistor (TFT) from impurities such as alkali ions which leak from the base layer 201 or the underlying layers. The buffer layer 202 may be made of silicon oxide (SiOx), silicon nitride (SiNx), or multiple layers thereof.

When the base layer 201 is made of a plastic material and the buffer layer 202 including silicon nitride (SiNx) is used, hydrogen or moisture may move to overlying layers from the base layer 201 or the buffer layer 202, thereby affecting the semiconductor layer 212 of the thin-film transistor. Further, when the base layer 201 is made of a plastic material, a separate support substrate (transfer substrate) is attached under the base layer 201 so as to support the base layer 201 during the fabricating process. A sacrificial layer is disposed between the base layer 201 and the support substrate. Once the fabricating process is completed, the base layer 201 may be separated from the support substrate via a laser release process. During the laser release process, the semiconductor layer 212 of the thin-film transistor formed on the base layer 201 may be damaged by the laser irradiated. In addition, the threshold voltage (Vth) of the thin-film transistor may be varied due to a current drop generated by the base layer 201 and the sacrificial layer. Specifically, a negative charge trap is generated in the sacrificial layer by the laser and light coming from the outside, such that positive (+) charges in a plastic material of the base layer 201, e.g., polyimide (PI) move to the sacrificial layer. As a result, the potential on the surface of the base layer 201 increases, and the threshold voltage Vth of the thin-film transistor may be shifted in the positive direction. Such shift of the threshold voltage (Vth) lowers the reliability of the organic light-emitting display device 100. In view of the above, the organic light-emitting display device 200 according to various exemplary embodiments of the present disclosure may further include a bottom shield metal (BSM) layer.

The bottom shield metal layer 280 is disposed on the buffer layer 202. The bottom shield metal layer 280 may be disposed on the buffer layer such that the bottom shield metal layer 280 overlaps with the semiconductor layer 212 of the thin-film transistor. In some embodiments, the semiconductor layer 212 of the thin-film transistor completely overlaps with the bottom shield metal layer 280. In the cross-sectional view, the width of the bottom shield metal layer 280 may be equal to or greater than the width of the semiconductor layer 212. The bottom shield metal layer 280 may be made of various metal materials, and the bottom shield metal layer 280 may receive a voltage or may "float." For example, the bottom shield metal layer 280 of FIG. 2B is connected to the source electrode 218 of the driving transistor D-Tr.

On the bottom shield metal layer 280, an active buffer 203 for insulating the bottom shield metal layer 280 from the semiconductor layer 212 is disposed. The active buffer 203 may be made of the same material as the buffer layer 202. For example, the active buffer 203 may be a single layer of silicon nitride (SiNx) or silicon oxide (SiOx), or multiple layers of silicon nitride (SiNx) and silicon oxide (SiOx).

The thin-film transistor is disposed on the active buffer 203 or on the base layer 201. The thin-film transistor may be formed by sequentially stacking a semiconductor layer 212, a gate insulating layer 205, a gate electrode 214, an interlayer dielectric layer 207, and a source and drain electrode 218. The semiconductor layer 212 may be made of a polysilicon (p-Si), a predetermined region of which may be doped with impurities. In addition, the semiconductor layer 212 may be made of amorphous silicon (a-Si) or may be made of a variety of organic semiconductor materials such as pentacene. Furthermore, the semiconductor layer 212 may be made of oxide as well.

The gate electrode 214 may be made of a variety of conductive materials such as magnesium (Mg), aluminum (Al), nickel (Ni), chrome (Cr), molybdenum (Mo), tungsten (W), gold (Au), or an alloy thereof.

The gate insulating layer 205 and interlayer dielectric layer 207 may be formed of an insulation material such as silicon oxide (SiOx) and silicon nitride (SiNx) or may be made of an insulation organic material. By selectively removing the gate insulating layer 205 and the interlayer dielectric layer 207, contact holes may be formed via which a source region and a drain region are exposed, respectively.

The source and drain electrode 218 is formed on the gate insulating layer 205 or the interlayer dielectric layer 207 with a material for an electrode and is made up of a single layer or multiple layers. A passivation layer made of an inorganic insulating material may cover the source and drain electrode 218, as desired.

The source electrode 218 of the thin-film transistor may be connected to the bottom shield metal layer 280 through a contact hole. Accordingly, the same voltage is applied to the bottom shield metal layer 280 as the source electrode 218 of the thin-film transistor. By virtue of the bottom shield metal layer 280, hydrogen or moisture can be blocked, and the laser irradiated during the laser release process can also be blocked. In addition, it is possible to suppress or reduce a shift of the threshold voltage Vth of the thin-film transistor that may occur as the potential on the surface of the base layer 201 increases.

A planarization layer 209 may be disposed on the thin-film transistor. The planarization layer 209 protects the thin-film transistor and provides a flat surface over it. The planarization layer 209 may have a variety of forms. For example, the planarization layer 209 may be made of an organic insulation film such as BCB (benzocyclobutene) and acryl or may be made of an inorganic insulation film such as silicon nitride (SiNx) film and silicon oxide (SiOx) film. In addition, the passivation layer 209 may be made up of a single layer, a double layer, or a multi-layer.

The organic light-emitting element may be formed by stacking a first electrode 232, an organic emission layer 234, and a second electrode 236 in this order. That is, the organic light-emitting element may include the first electrode 232 formed on the passivation layer 209, the organic emission layer 234 disposed on the first electrode 232, and the second electrode 236 disposed on the organic emission layer 234.

The first electrode 232 is electrically connected to the drain electrode 218 of the driving thin-film transistor via the contact hole. In the case where the organic light-emitting display device 100 is of top-emission type, the first electrode 232 may be made of an opaque conductive material having high reflectivity. For example, the first electrode 232 may be made of silver (Ag), aluminum (Al), gold (Au), molybdenum (Mo), tungsten (W), chrome (Cr) or an alloy thereof. The first electrode 232 may be the anode of the organic light-emitting diode.

A bank 210 is formed in the rest of the area except an emission area. Accordingly, the bank 210 has a bank hole corresponding to the emission area, via which the first electrode 232 is exposed. The bank 210 may be made of either an inorganic insulation material such as silicon nitride (SiNx) layer and silicon oxide (SiOx) layer or an organic insulation material such as BCB, acryl-based resin or imide-based resin.

The organic emission layer 234 is disposed on the first electrode 232 exposed via the hole of the bank 210. The organic emission layer 234 may include an emissive layer, an electron injection layer, an electron transport layer, a hole transport layer, a hole injection layer, etc. The organic emission layer may be made up of a single emissive layer emitting light of a color or may be made up of a plurality of emissive layers to emit white light.

The second electrode 236 is disposed on the organic emission layer 234. In the case where the organic light-emitting display device 200 is of top-emission type, the second electrode 236 is made of a transparent, conductive material such as indium tin oxide (ITO) or indium zinc oxide (IZO), such that light generated in the organic emission layer 234 exits upwardly through the second electrode 236. The second electrode 236 may be the cathode of the organic light-emitting diode.

**FIG. 2C** is a timing diagram illustrating driving timings of the pixel circuit shown in FIG. 2A. Referring to FIG. 2C, a single frame may be divided into a first time period T1 and a second time period T2. The first time period is a data write and hold period in which output data (image signal) is written to each pixel and is held for a predetermined time, and the second time period is an emission period in which light is emitted depending on the written data. The data write & hold period may be further divided into a data write period in which data is written into each pixel, and a data hold period in which the written data is held for a predetermined period of time. The data write & hold period may further include additional operation periods such as a sampling period and an initialization period.

As the gate signals are sequentially applied to the gate lines GL1, GL2, ..., and gate line in this order, the data write period of each of the pixels may be located sequentially in the order of the gate lines GL1, GL2, ..., and GLn, as shown in FIG. 2C. As a result, for each of the pixels, the data hold period refers to the rest of the data write & hold period after the data write period has been elapsed. Accordingly, the length of the data hold period may vary from pixel to pixel.

The first transistor Tr1 is turned on while the data voltage Vdata is applied to the driving transistor D-Tr during the first time period T1. In other words, the gate signal SCAN1 applied to a pixel remains at the high state during the data write period and remains at the low state during the rest of the period. Accordingly, the first transistor Tr1 is turned on by the gate signal SCAN1 during the data write period to apply the data voltage Vdata to the first node (G node) of the driving transistor D-Tr.

The second transistor Tr2 is turned on while the reference voltage Vref is applied to the driving transistor D-Tr during the first time period T1, to apply the reference voltage Vref to the second node (S node) of the driving transistor D-Tr.

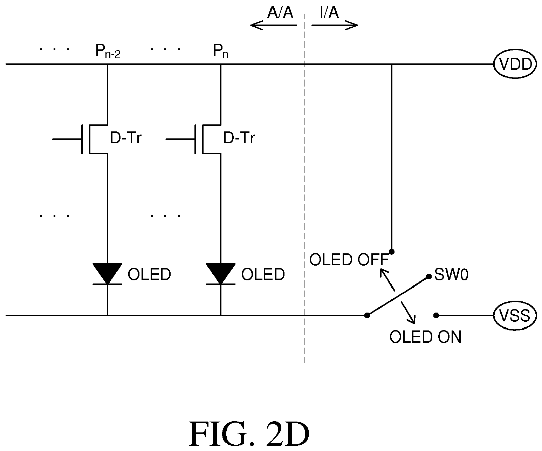

The OLED does not emit light during the first time period T1, i.e., while data is being written to all the pixels. Referring to **FIGS. 2C** **and** **2D**, since a switch SW0 connected to the cathodes of the OLEDs included in all the pixel circuits is connected to the high-level voltage terminal VDD during the first time period T1, no current flows through the OLED, and thus the OLED does not emit light. On the other hand, when the data has been written in all the pixels and the second time period T2 is started, the switch SW0 is connected to the low-level voltage terminal VSS so that the OLEDs of all the pixels emit light.

In this manner, all the pixels of the organic light-emitting display device are configured to emit light at the same time point (time period) because of the usage environment of the VR device. Usually, a virtual reality (VR) display device is mounted closely to a user's eyes in order to increase the level of immersion. Accordingly, if data write and emission of each pixel are sequentially performed (so-called rolling shutter operation) like other organic light-emitting display devices, the sequential emission of the horizontal lines may be perceived by the user, or a quickly-changing image may be distorted. Therefore, in order to prevent deterioration of the visual sensitivity, the organic light-emitting display device for a VR device is driven such that the OLEDs of all the pixels emit light simultaneously, which is often referred to as global shutter operation.

A certain voltage (Vref in the circuit shown in FIG. 2A) may be applied to the bottom shield metal layer BSM. In this instance, the voltage VBSM applied to the bottom shield metal layer is held at the reference voltage Vref during the first time period T1 and the second time period T2 after the second transistor Tr2 has been turned on.

As described above, although the stability of the thin-film transistor has been improved by employing the bottom shield metal layer, there is also a problem with the voltage (e.g. Vref) applied to the bottom shield metal layer BSM. Specifically, there are issues of recoverable residual image and luminance degradation. As the global shutter operation is performed, a current flows through the source electrode of the driving transistor D-Tr for a period of time equal to a frame, such that the voltage at the node of the source electrode rises up to the high-level voltage VDD. Accordingly, the voltage at the bottom shield metal layer BSM connected to the node of the source electrode of the driving transistor D-Tr is equally increased. When the voltage at the bottom shield metal layer BSM rises, a back channel is formed by the bottom shield metal layer BSM, in addition to the channel formed by the gate electrode of the driving transistor. Due to the back channel, the hysteresis characteristic of the TFT is deteriorated, such that a recoverable residual image may appear. In order to reduce such variations, it may be contemplated to change the scan timing to compensate for the mobility deviation of the driving transistor D-Tr. By doing so, however, there is also the adverse effect that the response speed is deteriorated. As another approach, it may be contemplated to connect the bottom shield metal layer BSM to another power source to supply a constant voltage (e.g., 0V). However, it has been observed that the luminance appears below the target value. In particular, the threshold voltage of driving transistor changes based on the voltage difference between the body and the source electrode (VBS) of the driving transistor. In the embodiment where a constant voltage is supplied to the bottom shield metal layer, the voltage difference between the body electrode and source electrode (VBSM - Vsource) shifts the threshold voltage in the positive direction, reducing the drain current of the driving transistor, thus, degrading the luminance of the OLED. To mitigate the appearance of a recoverable residual image, while maintaining a response speed, a pixel circuit structure capable of solving the problems caused by the bottom shield metal layer is disclosed hereinafter.

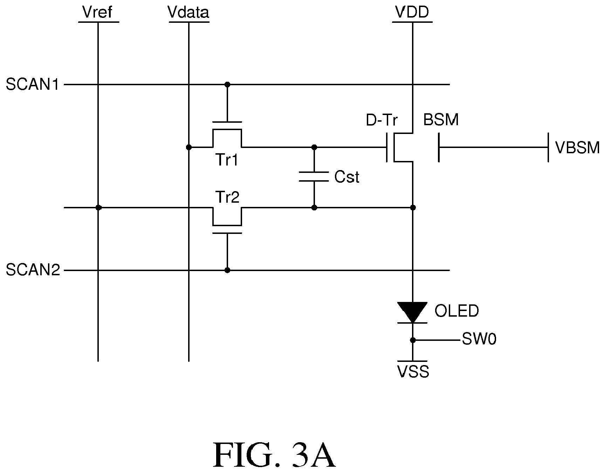

**FIGS. 3A to 3C** are exemplary diagrams showing an organic light-emitting display device according to an exemplary embodiment of the present disclosure and driving the same.

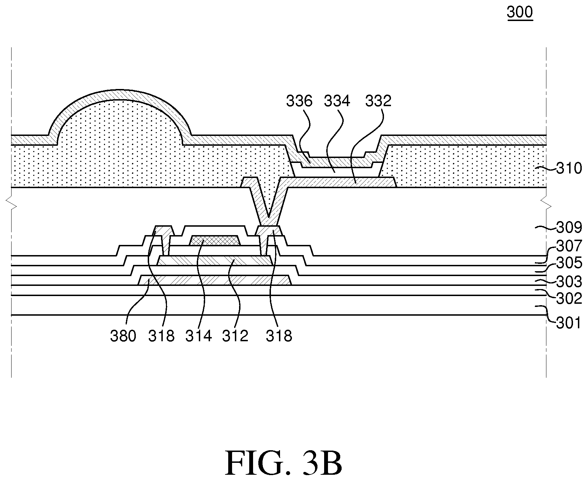

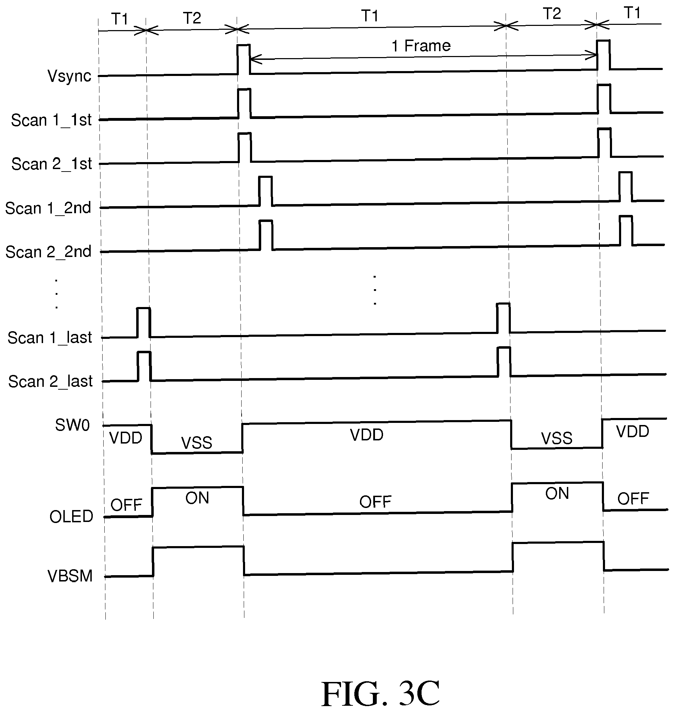

**FIG. 3A** is a diagram illustrating a unit pixel circuit of an organic light-emitting display device according to an exemplary embodiment of the present disclosure. **FIG. 3C** is a diagram showing operation timing of elements included in the pixel circuit. In **FIGS. 3A** **and** **3B**, the elements and the operation are substantially identical to those described above with reference to FIGS. 2A to 2D except a bottom shield metal (BSM) layer 380; and, therefore, the redundant description will be omitted. It is to be noted that the organic light-emitting display device described below includes a separate power source for controlling the power supply to the bottom shield metal (BSM) layer, unlike the device shown in FIGS. 2A to 2D. The description will be made focusing on the differences.

As shown in FIGS. 3A and 3B, the bottom shield metal (BSM) layer 380 is not connected to the driving transistor D-Tr but is connected to a dedicated power source VBSM. Further, the voltage supplied to the bottom shield metal layer 380 varies at specific time points in conjunction with the operation (data write and emission) timing of the pixel, as shown in **FIG. 3C**. For example, referring to FIG. 3C, during an addressing period such as a first time period T1, the voltage VBSM supplied to the bottom shield metal layer 380 is held at the ground voltage (e.g., 0 V). During an emission period such as a second time period T2, the voltage VBSM supplied to the bottom shield metal layer 380 rises up to a predetermined voltage (e.g., 2.5 V) or more. In this manner, the bottom shield metal layer 380 is held at a constant voltage during the first time period T1, thereby improving the residual image and response speed. During the second time period T2, the bottom shield metal layer has a predetermined potential, thereby solving luminance degradation. The operation of supplying power to the bottom shield metal layer 380 in accordance with the timing may be performed by T-CON, D-IC, PMIC, or the like. The bottom shield metal layer 380 may be connected to the power source outside the pixel. For example, the bottom shield metal layer 380 may be connected to the wiring of the power source in the inactive area (bezel) . In this case, the bottom shield metal layer 380 may be made up of a piece of metal extending vertically and/or horizontally across the plurality of pixels.

The organic light-emitting display device 300 according to the exemplary embodiment of the present disclosure can be applied to a virtual reality (VR) device. The organic light-emitting display device 300 may include a plurality of pixels each including a driving transistor D-Tr and an organic light-emitting diode (OLED). The driving transistor D-Tr includes a gate electrode; a source electrode connected to the OLED; and a drain electrode connected to the high-potential power voltage terminal VDD. The OLED has an anode connected to the source electrode of the driving transistor D-Tr and a cathode connected to a low-level voltage terminal VSS. The organic light-emitting diode display 300 may further include a switch SW0 connected between the low-potential power voltage terminal and the cathode of the organic light emitting diode; and a bottom shield metal layer 380 disposed under the semiconductor layer 312 of the driving transistor D-Tr and connected to a predetermined power source. The organic light-emitting diode may be turned off during the first time period T1 and turned on during the second time period T2. The first time period T1 is a period of time in which an image signal (e.g., Vdata) is transmitted to the driving transistor D-Transistor, and the second time period T2 is a period of time in which the organic light-emitting diode (OLED) emits light based on the transmitted image signal. Each single frame consists of the first time period T1 and the second time period T2.

The switch SW0 may be connected to all of the plurality of pixels and may control the emission of the organic light-emitting diodes (OLEDs) included in the plurality of pixels, respectively. That is, the switch SW0 may be operated such that the OLEDs are turned off together during the first time period T1 and are turned on together during the second time period T2. The switch SW0 may be disposed outside the pixel circuits (e.g., outside the active area) . Furthermore, a power controller for controlling the switch may be further provided in the organic light-emitting display device. The switch SW0 and the power controller may be included in a power management integrated circuit (PMIC) located outside the active area where the pixel circuits are disposed. The power management integrated circuit may be mounted on a chip, a printed circuit board (PCB) or the like and connected to a substrate, or may be implemented directly in an inactive area in a substrate.

The bottom shield metal layer 380 may receive a predetermined voltage during a period of time during which the OLED is turned on. The predetermined voltage may be 2.5 volts (V) or more. In addition, the bottom shield metal layer 380 may receive a ground voltage (e.g., 0V) during a period of time during which the OLED is turned off. The bottom shield metal layer 380 may be connected to the wiring of the power source in the inactive area.

As shown in FIG. 3A, the organic light-emitting display device 300 according to an exemplary embodiment of the present disclosure may include a first transistor Tr1 electrically connected between a data line DL for supplying data voltage data and a gate electrode of a driving transistor D-Tr and being switched by a first gate signal SCAN1 applied through a first gate line; a second transistor Tr2 electrically connected between a reference voltage line for supplying reference voltage Vref and a source electrode of the driving transistor D-Tr and being switched by a second gate signal SCAN2 applied through a second gate line; and a capacitor Cst electrically connected between the gate electrode and the source electrode of the driving transistor D-Tr.

The first transistor Tr1 is turned on/off or switched by the first gate signal SCAN1 applied through the first gate line. When the first transistor Tr1 is turned on by the first gate signal SCAN1, the first transistor Tr1 applies the data voltage Vdata to the first node (G node) of the driving transistor D-Tr. The second transistor Tr2 is turned on/off or switched by the second gate signal SCAN2 applied through the second gate line. When the second transistor Tr2 is turned on by the second gate signal SCAN2, the second transistor Tr2 applies the reference voltage Vref to the second node (S node) of the driving transistor D-Tr. The capacitor Cst holds the data information Vgs that is equal to the difference between the data voltage Vdata (= VG) applied to the first node (G node) of the driving transistor D-Tr and the reference voltage Vref (= VS) applied to the second node (S node) for one frame.

The organic light-emitting display device having the above-described configuration according to the exemplary embodiments of the present disclosure can improve the issues of recoverable residual image/the degradations of response characteristics and luminance. Furthermore, the organic light-emitting display device according to the exemplary embodiment of the present disclosure can be fabricated more simply than the existing organic light-emitting display devices. Specifically, in the configuration shown in FIG. 2B, three contact holes and one bridge are used to connect the bottom shield metal layer to the node of the source electrode of the driving transistor. In contrast, according to an exemplary embodiment of the present disclosure, no additional contact hole is required since the bottom shield metal layer is not connected to any node within the pixel. As a result, the fabricating process can become simpler, reducing defects due to the process. Further, the capacitance can be increased by utilizing the space that was occupied by the contact holes/bridge, thereby improving the display performance.

The exemplary embodiments of the present disclosure can also be described as follows:

A display device may comprise: a substrate; an array of thin film transistors on the substrate, the array of thin film transistors in an active area of the display device; and a shield metal between at least one of the thin film transistors and the substrate, the shield metal receiving a first voltage during an addressing period and a second voltage during an emission period, the first voltage different from the second voltage.

In such a display device, the shield metal may be held at a constant voltage during the addressing period, thereby improving the residual image and response speed.

Alternatively, the shield metal may have a specific voltage during the emission period, thereby reducing luminance degradation, wherein the specific voltage is larger than 0V.

For example, the first voltage may be a ground voltage and the second voltage may be 2.5 V or more.

The display device may further comprise: an organic light-emitting diode connected to at least one of the thin film transistors; and a switch turning on the organic light-emitting diode in the emission period and turning off the organic light-emitting diode in the addressing period.

Thus far, exemplary embodiments of the present disclosure have been described in detail with reference to the accompanying drawings. However, the present disclosure is not limited to the exemplary embodiments, and modifications and variations can be made thereto without departing from the technical idea of the present disclosure. Accordingly, the exemplary embodiments described herein are merely illustrative and are not intended to limit the scope of the present disclosure. The technical idea of the present invention is not limited by the exemplary embodiments. Features of various exemplary embodiments of the present disclosure may be combined partially or totally. As will be clearly appreciated by those skilled in the art, technically various interactions and operations are possible. Various exemplary embodiments can be practiced individually or in combination. The scope of protection sought by the present disclosure is defined by the appended claims and equivalents thereof.

## Claims

1. A display device (100) comprising:
a substrate (301);
a bottom shield metal layer (380) on the substrate, the bottom shield metal layer (380) configured to be coupled to a voltage source (VBSM);
a driving transistor (D-Tr) having a source terminal and a drain terminal, the driving transistor (D-Tr) arranged above the bottom shield metal layer (380), a first one of the terminals of the driving transistor configured to be coupled to a reference voltage (Vref) for setting a voltage value at the first terminal, the coupling of the bottom shield metal layer (380) to the voltage source (VBSM) being independent of the coupling of the first terminal to the reference voltage (Vref); and
an organic light emitting diode (OLED) having a first electrode coupled to the first terminal of the driving transistor (D-Tr).

2. The display device of claim 1, configured to set the voltage source (VBSM) at a voltage value lower than a voltage at which a back channel is formed in the driving transistor (D-Tr).

3. The display device of claim 1 or 2, wherein the voltage source (VBSM) is configured to have a first voltage value during a first period (T1) when the OLED is configured not to emit light, and has a second voltage value during a second period (T2) when the OLED is configured to emit light.

4. The display device of claim 3, wherein the first voltage value is lower than the second voltage value.

5. The display device of claim 3 or 4, wherein the first voltage value is 0V.

6. The display device of any one of claims 3 to 5, wherein the first period (T1) is a data write and hold period for storing display data to a capacitor (Cst) of the display device.

7. The display device of any one of claims 1 to 6, configured to operate in a global shutter operation mode, wherein every pixel (P) of the display device is configured to turn on or off simultaneously.

8. The display device of any one of claims 1 to 7, wherein the bottom shield metal layer is connected to the voltage source (VBSM) in an inactive area of the display device where no display pixels are present.

9. The display device of any one of claims 1 to 8, further comprising:
a switch (SW0) coupled to the OLED, the switch configured to couple a second electrode of the OLED to a first voltage (VSS) to turn on the OLED, or to couple the second electrode of the OLED to a second voltage (VDD) to turn off the OLED.

10. The display device of any one of claims 1 to 9, wherein the bottom shield metal layer (380) at least partially overlaps with a semiconductor layer (312) of the driving transistor (D-Tr).

11. The display device of any one of claims 1 to 10, wherein the bottom shield metal layer (380) and a gate (314) of the driving transistor (D-Tr) are at opposite sides of a semiconductor layer (312) of the driving transistor.

12. A method for operating a display device (100), comprising:
during a first period (T1) when an organic light emitting diode (OLED) of the display device does not emit light:
providing a first voltage to a bottom shield metal layer (380), the bottom shield metal layer arranged under a driving transistor (D-Tr) of the display device; and
during a second period (T2) when the OLED of the display device emits light:
providing a second voltage to the bottom shield metal layer (380), wherein the first voltage and the second voltage are different.

13. The method of claim 12, wherein the first voltage is lower than the second voltage.

14. The method of claim 12 or 13, wherein the first period (T1) is a data write and hold period for storing display data to a capacitor (Cst) of the display device.

15. The method of any one of claims 12 to 14, wherein the display device operates in a global shutter operation mode, wherein every pixel (P) of the display device turns on or off substantially at a same time.
